# EUROPEAN PATENT APPLICATION

(11) **EP 4 213 220 A1**
(43) Date of publication of application: **19.07.2023**
(21) Application number: 20950478.6
(22) Date of filing: 09.09.2020
(51) Int. Cl.: H01L 31/0224, H01B 5/14, H05B 33/28

(54) **TRANSPARENT ELECTRODE, METHOD FOR MANUFACTURING TRANSPARENT ELECTRODE, AND ELECTRONIC DEVICE**

(71) Applicant: KABUSHIKI KAISHA TOSHIBA, Minato-ku Tokyo 105-0023 (JP)
(72) Inventor: SHIDA Naomi, Minato-ku, Tokyo 1050023 (JP); NAITO Katsuyuki, Minato-ku, Tokyo 1050023 (JP); SAITA Yutaka, Kawasaki-shi, Kanagawa 2120013 (JP)
(74) Representative: Hoffmann Eitle
(86) International application number: PCT/JP2020/034040
(87) International publication number: WO 2022/054150

(57) **Abstract**

Provided are a stable patterned transparent electrode with low resistance and simple production, a method of producing the same, and an electronic device using the same.

A transparent electrode according to an embodiment is a transparent electrode including a transparent substrate and a plurality of conductive regions disposed on a surface of the transparent substrate and separated from each other by a high resistance region, wherein the conductive regions have a structure in which a first transparent conductive metal oxide layer, a metal layer, a second transparent conductive metal oxide layer, and a graphene-containing layer are laminated in order from the side of the substrate, and the transparent electrode with no compound having a graphene skeleton in the high resistance region can be produced by forming the graphene-containing layer and then patterning.

## Description

### FIELD

Embodiments relate to a transparent electrode, a method of producing the transparent electrode, and an electronic device.

### BACKGROUND

In recent years, energy consumption has been increasing, and there is an increasing demand for alternative energy to replace conventional fossil energy as a global warming countermeasure. Attention has been focused on a solar cell as a source of such alternative energy, and development of the solar cell has been in progress. Use of the solar cell for various applications has been investigated; however, flexibility and durability of the solar cell are particularly important in order to cope with various installation places. The most basic monocrystalline silicon-based solar cell is expensive and difficult to be made flexible, and organic solar cells and organic-inorganic hybrid solar cells that have recently attracted attention have room for improvement in terms of durability.

In addition to such a solar cell, photoelectric conversion elements such as an organic EL element and an optical sensor have been investigated for the purpose of flexibility and durability improvement. In such an element, an indium-doped tin (ITO) film is widely used as a transparent electrode. The ITO film is typically formed by sputtering or the like, and in order to achieve high conductivity, sputtering at a high temperature or high-temperature annealing after sputtering is required, and the ITO film is often inapplicable to an element including an organic material.

ITO/Ag/ITO having low resistance and high transparency may be used as a transparent electrode. There is an investigation example in which such an electrode is used for an element having a PEDOT/PSS layer, and amorphous ITO (hereinafter, sometimes referred to as a-ITO) and silver used for an ITO film are deteriorated by an acid and a halogen, whereby the performance of the electrode is strongly tended to be deteriorated. Furthermore, silver migrates easily, and reacts with water or the like in the active part of the element or the like, which may reduce the activity itself of the element.

In order to improve such a problem, it has also been investigated to provide a barrier layer including, for example, graphene to suppress migration of silver or halogen.

### PRIOR ART DOCUMENT

### PATENT DOCUMENT

Patent Document 1: JP 2014-532025 A

### DISCLOSURE OF INVENTION

### PROBLEM TO BE SOLVED BY THE INVENTION

However, the investigation of the present inventors has found that deterioration of the element caused by the graphene compound can occur when the transparent electrode is formed. In view of such a problem, an object of the present embodiment is to provide a stable transparent electrode having small migration of metal or halogen, a method of producing the transparent electrode, and an electronic device using the transparent electrode.

### MEANS FOR SOLVING PROBLEM

A transparent electrode according to an embodiment includes a transparent substrate and a plurality of conductive regions disposed on a surface of said transparent substrate and separated from each other by a high resistance region, wherein said conductive regions have a structure in which a first transparent conductive metal oxide layer, a metal layer, a second transparent conductive metal oxide layer, and a graphene-containing layer are laminated in this order from a side of the substrate, and
no compound having a graphene skeleton exists in said high resistance region.

In addition, a method of producing the transparent electrode according to the embodiment includes:
(a) a step of preparing a transparent substrate:
(b) a step of forming a laminate, comprising:
   (b1) a step of forming a first transparent conductive metal oxide layer on said transparent substrate;
   (b2) a step of forming a metal layer on said first transparent conductive metal oxide layer;
   (b3) a step of forming a second transparent conductive metal oxide layer on said metal layer; and
   (b4) a step of forming a graphene-containing layer on said second transparent conductive metal oxide layer; and
(c) a step of patterning said laminate to form a plurality of conductive regions.

In addition, the electronic device according to the embodiment has a structure in which said transparent electrode, an active layer, and a counter electrode are laminated in this order.

### BRIEF DESCRIPTION OF DRAWINGS

FIG. 1 is a conceptual view showing a structure of a transparent electrode according to an embodiment.
FIG. 2 is a conceptual view showing a method of producing a transparent electrode according to an embodiment.
FIG. 3 is a conceptual view showing a structure of a photoelectric conversion element (solar battery cell) according to an embodiment.
FIG. 4 is a conceptual view showing a structure of a photoelectric conversion element (organic EL element) according to an embodiment.
FIG. 5 is a conceptual view showing the transparent electrode in Example 1.
FIG. 6 is a conceptual view showing a solar battery cell in Example 5.

### DETAILED DESCRIPTION

Hereinafter, embodiments will be described in detail.

### [Embodiment 1]

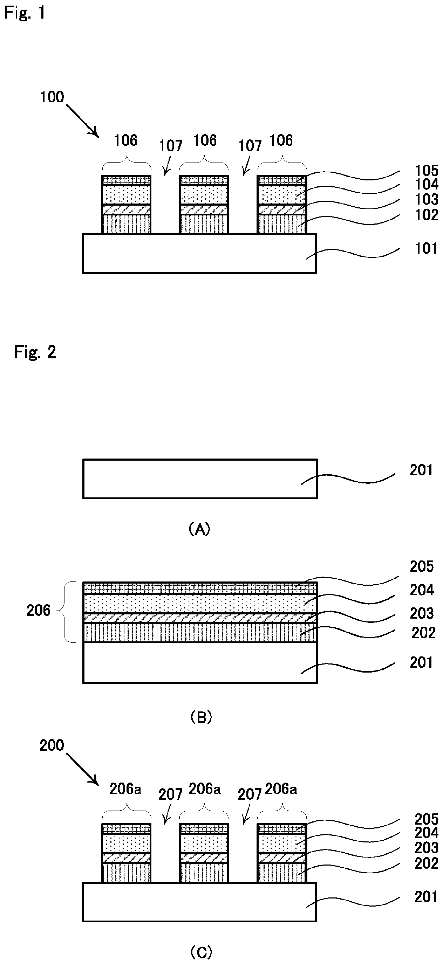

A configuration of the transparent electrode according to the first embodiment will be described below with reference to FIG. 1.

FIG. 1 is a schematic configuration view of a transparent electrode 100 according to the present embodiment. This transparent electrode includes a plurality of conductive regions 106 on a transparent substrate 101, and the plurality of conductive regions 106 are separated from each other by a high resistance region 107.

The conductive region 106 includes a first transparent conductive metal oxide layer (hereinafter, sometimes referred to as a first oxide layer) 102, a metal layer 103, and a second transparent conductive oxide (hereinafter, sometimes referred to as a second oxide layer) 104, and a graphene-containing layer 105 formed thereon in this order from the substrate side.

In the embodiment, no compound having a graphene skeleton exists in the high resistance region. Herein, the compound having a graphene skeleton includes graphene derived from the graphene-containing layer 105 and graphene oxide derived from a graphene oxide-containing layer formed as necessary. The absence of the compound having a graphene skeleton in the high resistance region means that no graphene is attached to the surfaces of the first and second oxide layers and the metal layer, particularly the metal layer, exposed on the side wall of the conductive region 106.

A second oxide layer 104 has effects of suppressing migration of a metal such as silver from the metal layer 103 to the active layer formed on the transparent electrode and suppressing migration of halogen ions and the like from the active layer to the metal electrode. The graphene-containing layer 105 has a function of improving the effect. However, the compound having a graphene skeleton in the high resistance region may promote deterioration of the conductive region. The reason for this is considered to be that when the compound having a graphene skeleton is present on the side surface of the conductive region exposed to the high resistance region, particularly on the side surface of the metal layer 103, halogen ions, moisture, and the like are attracted, and the concentration of halogen ions and moisture in the portion increases, thereby damaging the metal layer and the like. Such a graphene-containing compound may be mixed in the high resistance region as dust in the production process or may be inevitably present in the high resistance region depending on the production method, and thus it is preferable to produce the graphene-containing compound by a specific production method (details will be described later).

Hereinafter, the configuration of the transparent electrode according to the first embodiment will be described in detail.

An inorganic material such as glass, and an organic material such as polyethylene terephthalate (hereinafter, referred to as PET), polyethylene naphthalate (hereinafter, referred to as PEN), polycarbonate, and PMMA are used as a material of the transparent substrate 101. Use of a flexible organic material is preferable because the photoelectric conversion element according to the embodiment has high flexibility. In addition, the transparent substrate is preferably subjected to a flattening treatment in order to provide light transmissivity and suppress occurrence of defects during the production.

The material of the first oxide layer 102 can be selected from any widely known materials. Specific examples thereof include indium-doped tin oxide (ITO: indium doped tin oxide), fluorine-doped tin oxide (FTO: fluorine doped tin oxide), aluminum-doped zinc oxide (AZO: aluminium doped zinc oxide), and indium-doped zinc oxide (IZO: indium doped zinc oxide), and the like. The above metal oxide contains an amorphous structure, and the film thickness is preferably 30 to 200 nm, more preferably 35 to 100 nm, and still more preferably 40 to 70 nm. The amorphous structure easily forms a continuous, uniform, and flat film. An excessively small film thickness tends to increase the resistance, and an excessively large film thickness decreases the transparency, taking time to form the film. Of the above materials, ITO is preferable because the zeta potential is close to 0 at a neutral pH and the interaction with cations or anions is small.

Examples of the material of the metal layer 103 include silver, copper, gold, stainless steel, titanium, nickel, chromium, tungsten, molybdenum, tin, zinc, and alloys thereof, and silver, copper, and alloys thereof are preferable. The thickness of the metal layer 103 is preferably 4 to 20 nm, more preferably 5 to 15 nm, still more preferably 6 to 10 nm. An excessively small film thickness tends to increase the resistance, and an excessively large film thickness tends to decrease the transparency. Silver tends to migrate easily; however, is excellent in conductivity, and copper has higher migration resistance than silver and is cheaper; however, has lower conductivity. Combining these in a well-balanced manner can achieve both conductivity and the effect of migration suppression.

The material of the second oxide layer 104 can be selected from the same materials as those listed for the first oxide layer. The same material is preferably used for the first oxide layer 102 and the second oxide layer 104. The thickness of the second oxide layer is preferably 5 to 50 nm, more preferably 10 to 40 nm, and still more preferably 15 to 30 nm. An excessively small film thickness tends to deteriorate the function of preventing migration of metal. An excessively large film thickness tends to increase the resistance, thereby hardly transferring charge. The second oxide layer 104 has an effect of suppressing migration, and the effect is significant when the oxide layer is continuous. Whether the oxide layer is continuous or not can be evaluated by cross-sectional SEM. Cross-sectional SEM can be measured at a magnification of 100000. The number of discontinuous portions measured in 10 sheets of cross-sectional SEM at different positions is preferably 2 or less, and more preferably 0.

The graphene-containing layer 105 according to the embodiment has a structure in which one to several layers of graphene having a sheet shape are laminated. The number of laminated graphene layers is not particularly limited, and is preferably 1 to 6, and more preferably 2 to 4, in order to allow obtaining sufficient transparency, conductivity, or ion shielding effect.

The graphene preferably has a structure in which, for example, a polyalkyleneimine, particularly a polyethyleneimine chain is bonded to a graphene skeleton as shown in the following formula. In addition, the carbon of the graphene skeleton is preferably partially substituted with nitrogen.

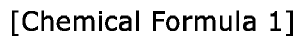

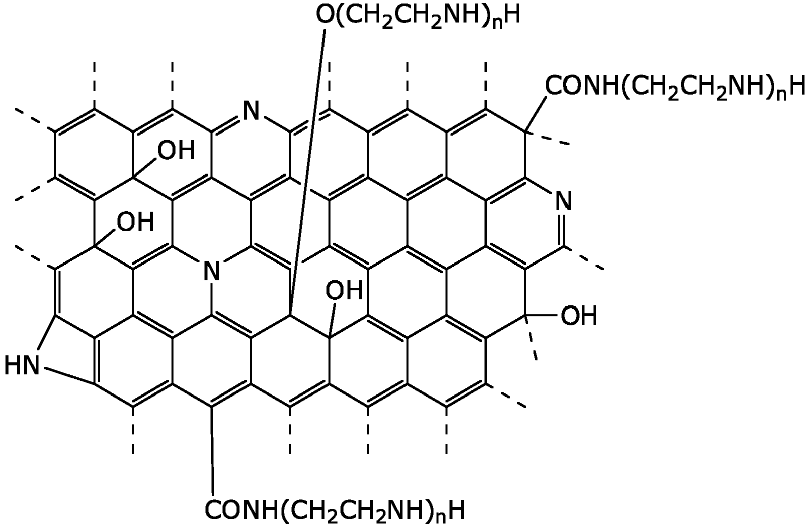

In the above formula, a polyethyleneimine chain is exemplified as a polyalkyleneimine chain. The number of carbon atoms included in the alkyleneimine unit is preferably 2 to 8, and polyethyleneimine including a unit having two carbon atoms is particularly preferable. In addition, there can be used not only the linear polyalkyleneimine but also a polyalkyleneimine having a branched chain or a cyclic structure. Herein, n (the number of repeating units) is preferably 10 to 1000, and more preferably 100 to 300.

The graphene is preferably unsubstituted or nitrogen-doped. Nitrogen-doped graphene is preferable for a negative electrode. The doping amount (N/C atomic ratio) can be measured by an X-ray photoelectron spectrum (XPS), and is preferably 0.1 to 30 atom%, and more preferably 1 to 10 atom%. The graphene-containing layer has a high shielding effect, and thus can prevent diffusion of acid and halogen ions to prevent deterioration of metal oxides and metals, and prevent intrusion of impurities from the outside into the photoelectric conversion layer. Furthermore, the nitrogen-substituted graphene-containing layer (N-graphene-containing layer) includes a nitrogen atom, and therefore the trapping ability against an acid is also high and the shielding effect is higher.

A metal oxide layer (third oxide layer) may be further provided on the graphene-containing layer. The presence of such a layer easily balances conductivity and a function of preventing migration of metal.

The oxide constituting the third oxide layer can be selected from, for example, titanium oxide, tin oxide, zinc oxide, and zirconium oxide. These easily become n-type semiconductors, and are preferable when an electrode is used as a negative electrode. Of these, titanium oxide and zirconium oxide are preferable because the oxide layer is stable and easily formed, the zeta potential is close to 0 at neutral pH, and the interaction with cations or anions is small. Furthermore, titanium oxide is more preferable from the viewpoint of supplying the raw material.

Each layer described herein may have a structure in which two or more layers are laminated. In this case, the materials and production method of the layers to be laminated may be the same or different.

In FIG. 1, the high resistance region 107 is a void; however, the high resistance region 107 may be filled with a material containing a p-type inorganic oxide, an n-type inorganic oxide, a p-type organic compound, or an n-type organic compound. In addition, other insulating materials may be filled. With such a configuration, although the conductive region is separated, the mechanical strength of a transparent substrate or the electronic device including the transparent substrate can be reinforced, or necessary electrical characteristics can be obtained. As an example of the material capable of being filled in the high resistance region, the n-type inorganic oxide can be selected from, for example, titanium oxide, tin oxide, zinc oxide, and zirconium oxide. The p-type inorganic oxide can be selected from nickel oxide, molybdenum oxide, iron oxide, and copper oxide. The p-type organic compound is preferably a polymer having a skeleton such as polythiophene or polyaniline. The n-type organic compound preferably has a fullerene skeleton.

In addition, a layer including a material containing a p-type inorganic oxide, an n-type inorganic oxide, a p-type organic compound, or an n-type organic compound can be provided on the graphene-containing layer 105. The material that can be used herein can be selected from the same materials as those that can be filled in the high resistance region described above.

Furthermore, a graphene oxide layer can be formed on the graphene-containing layer 105. Herein, the graphene oxide included in the graphene oxide-containing layer has a graphene skeleton oxidized, and is preferably unmodified. Laminating such an unmodified graphene oxide containing layer can increase the work function of the transparent electrode or the electronic device including the transparent electrode, and enhance the shielding property against ions.

### [Embodiment 2]

A method of producing a transparent electrode 200 according to the second embodiment will be described below with reference to FIG. 2.

A method of producing the transparent electrode according to the embodiment includes forming a laminate constituting a conductive region on a substrate, and then patterning the laminate to separate the laminate into a plurality of conductive regions.

A transparent substrate 201 is prepared (step (a), FIG. 2(A)). The transparent substrate 201 is preferably smooth, and can be subjected to smoothness treatment by polishing or the like and corona treatment prior to the production of the transparent substrate.

Then, a laminate constituting the conductive region is formed on the transparent substrate (step (b), FIG. 2(B)). The step (b) includes element steps in the following order:
(b1) a step of forming a first transparent conductive metal oxide layer 202 on the transparent substrate 201;
(b2) a step of forming a metal layer 203 on the first transparent conductive metal oxide layer 202;
(b3) a step of forming a second transparent conductive metal oxide layer 204 on the metal layer 203; and
(b4) a step of forming the graphene-containing layer 205 on the second transparent conductive metal oxide layer 204.

In the step (b1), the first oxide layer 202 is formed. The first oxide layer 202 can be formed, for example, by sputtering at a low temperature. The amorphous inorganic oxide layer can be formed by low-temperature sputtering, and the amorphous inorganic oxide can be partially crystallized by annealing to be formed into a mixture. Annealing is preferably performed in a high-temperature atmosphere or by laser annealing. The first oxide layer 202 is formed uniformly, that is, as an unpatterned uniform film on the substrate 201.

In the step (b2), the metal film 203 is formed. The metal layer 103 can be formed by, for example, sputtering or vapor deposition, and sputtering is preferable. This metal layer 203 is formed as a uniform film on the first oxide layer 202.

Then, in the step (b3), the second oxide layer 204 is formed. The second oxide layer can also be produced by a method selected from the same methods as those described for the first oxide layer. The materials and methods used may be the same as or different from those of the first oxide layer.

It has been described that the production can be mainly performed by sputtering in the steps (b1) to (b3), the method is not particularly limited, and the formation can be performed by an optional method.

Then, in the step (b4), the graphene-containing layer 205 is formed on the second oxide layer 204.

The graphene-containing layer can be formed by an optional method, and is preferably formed by a coating method. According to the coating method, the electrode can be easily produced although the substrate 201 or the second oxide layer 204 has a large area.

Typically, the graphene-containing layer 205 can be obtained by applying a dispersion liquid in which graphene is dispersed in a dispersion medium onto the second oxide layer 204 and, drying as necessary,. The graphene used herein may be unsubstituted or unmodified graphene, N-graphene in which carbon of a graphene skeleton is substituted with nitrogen, or modified graphene in which an alkyleneimine chain is bonded to a graphene skeleton. In addition, the graphene-containing layer can be formed by temporarily forming a graphene oxide-containing layer by using graphene oxide substituted with an alkyl chain or the like as graphene, and by reducing the graphene oxide by applying a hydrazine compound or an amine compound, for example, hydrated hydrazine, to the formed graphene oxide-containing layer.

Water, alcohols, dimethylformamide, methyl ethyl ketone, chlorbenzene, or a mixture thereof and a wide range of solvents are used as the dispersion medium included in the dispersion liquid containing graphene or the like. Of these, water is the most environmentally preferable and inexpensive.

The graphene-containing layer can also be formed by a method:
(i) forming an N-graphene-containing layer on the surface of the laminate by a chemical vapor deposition method with combining a low-molecular nitrogen compound such as ammonia, pyridine, methylamine, ethylenediamine, or urea in addition to a basic raw material such as methane or hydrogen;
(ii) forming the graphene-containing layer on another substrate and then transferring it onto the laminate; or
(iii) forming an unsubstituted graphene film on the surface of the laminate and then perform the treatment in nitrogen plasma to perform the production.

As necessary, the other layer can be formed before and after the step (b) or between the steps (b1) to (b4). Particularly, after the step (b4), a step (step (b5)) of forming a graphene oxide containing layer on the graphene-containing layer can also be added. For example, the graphene-oxide aqueous dispersion liquid, by which the graphene-oxide dispersion liquid can be applied onto the graphene-containing layer, has high affinity with the underlying graphene-containing layer, and therefore a uniform film is easily formed. The graphene oxide may be dispersed in an organic solvent such as methanol or ethanol to be applied.

In addition, a step of forming a third oxide layer on the graphene-containing layer (step (b5')) can be added after the step (b4) as necessary.

The third oxide layer can be formed by various methods such as a sputtering method and a sol-gel method, and the formation is preferably performed by applying an alcohol solution of a metal alkoxide and then performing a heat treatment in a water-containing atmosphere because a thin and uniform amorphous film having a large area can be formed.

Both the step (b5) and step (b5') can be added, and in this case, any of these steps may be performed previously.

In addition, the first transparent conductive metal oxide layer, the metal layer, the second transparent conductive metal oxide layer, or the graphene-containing layer can be produced in two or more stages, respectively. In this case, the materials and methods used in the respective stages may be the same or different.

The laminate 206 is formed in this manner, and then the laminate is separated by patterning to form a plurality of conductive regions 206a (step (c), FIG. 2(C)). A portion where the laminate is removed by patterning becomes a high resistance region 207.

The patterning can be performed by an optional method, and mechanical scribing, laser scribing, or etching is preferably used. In the embodiment, it is desirable to avoid the compound having a graphene skeleton from entering the high resistance region. Therefore, there is preferable mechanical scribing or laser scribing in which dust or the like is hardly mixed into the high resistance region. Patterning by etching is also possible, and particularly in wet etching, impurities mixed in the liquid easily enter the high resistance region, and thus it is preferable to remove the compound including a graphene skeleton from the high resistance region by post-treatment or the like.

In addition, in the embodiment, it is not preferable to perform the step of using the compound having a graphene skeleton after the step (c). For example, after the graphene-containing layer 205 is formed as described above, a graphene oxide-containing layer can be formed thereon; however, the formation of the graphene oxide-containing layer should be performed before the patterning step (c). The high resistance region can be filled with a semiconductor material or the like; however, as long as the high resistance region is filled with the material, the graphene or the like does not enter the high resistance region when used.

For such purposes or to improve the electrical properties of the transparent electrode or the electronic device comprising the same, various semiconductor materials and the like can be filled in the high resistance region after the step (c). Specifically, a semiconductor material can be laminated by sputtering or the like, or an aqueous dispersion including a semiconductor material or the like can be applied.

### [Embodiment 3-1]

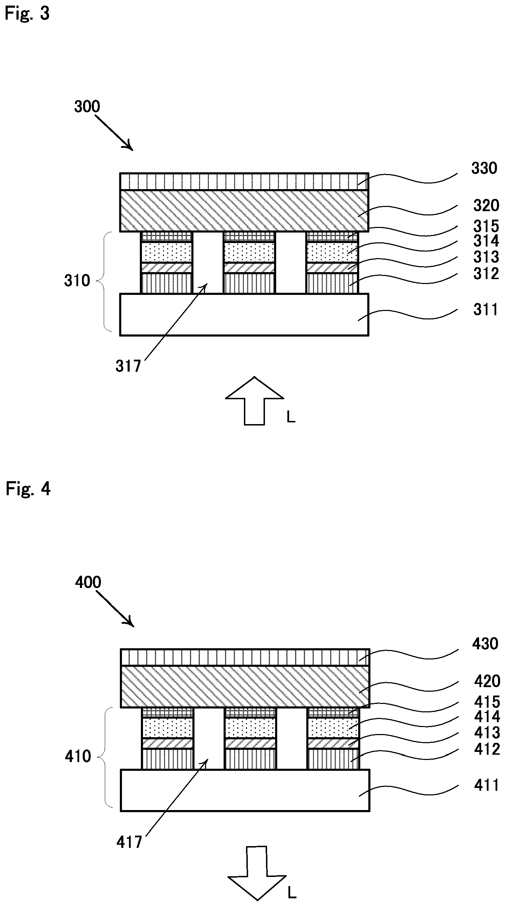

A configuration of the electronic device according to one of the third embodiments will be described with reference to FIG. 3. FIG. 3 is a schematic configuration view of a photoelectric conversion element (solar battery cell) 300 that is an example of the electronic device according to the present embodiment. The solar battery cell 300 is an element having a function as a solar battery that converts light energy such as the sunlight L incident on the cell into electric power. The solar battery cell 300 includes a transparent electrode 310 according to the embodiment, a counter electrode 330, and a photoelectric conversion layer 320 provided therebetween.

Herein, the transparent electrode 310 corresponds to the first embodiment, and has a plurality of conductive regions having a structure in which a transparent substrate 311, a first transparent conductive metal oxide layer 312, a metal layer 313, a second transparent conductive metal oxide layer 314, and a graphene-containing layer 315 are laminated, and there is a high resistance region 317 therebetween.

The photoelectric conversion layer 320 is a semiconductor layer that converts light energy of incident light into electric power to generate a current. The photoelectric conversion layer 320 generally includes a p-type semiconductor layer and an n-type semiconductor layer. There can be used, as the photoelectric conversion layer, a laminate of a p-type polymer and an n-type material, RNH₃PbX₃ (X represents a halogen ion, R represents an alkyl group and the like), a silicon semiconductor, an inorganic compound semiconductor such as InGaAs, GaAs, chalcopyrite, CdTe, InP, SiGe, or Cu2O, a quantum dot-containing transparent semiconductor, and a dye-sensitized transparent semiconductor. In any case, the efficiency is high, and the reduction of the output is small by providing the transparent electrode according to the embodiment.

A buffer layer may be inserted between the photoelectric conversion layer 320 and the transparent electrode 310 to promote or block charge injection. In addition, another charge buffer layer or charge transport layer may be inserted between the counter electrode 330 and the photoelectric conversion layer 320.

There can be used, as the buffer layer or the charge transport layer for a positive electrode, for example, a layer composed of vanadium oxide, PEDOT/PSS, a p-type polymer, vanadium pentoxide (V₂O₅), 2,2',7,7'-tetrakis[N,N-di(4-methoxyphenyl)amino]-9, 9 '-spirobifluorene (hereinafter, referred to as Spiro-OMeTAD), nickel oxide (NiO), tungsten trioxide (WO₃), or molybdenum trioxide (MoO₃).

Whereas, there can be used, as the buffer layer or the charge transport layer for a transparent electrode serving as a negative electrode, a layer composed of lithium fluoride (LiF), calcium (Ca), 6,6'-phenyl-C61-butyl acid methyl ester (6,6'-phenyl-C61-butyric acid methyl ester, C60-PCBM), 6,6'-phenyl-C 71-butyl acid methyl ester (6,6'-phenyl-C71-butyric acid methyl ester, hereinafter referred to as C70-PCBM), indene-C60 bis-adduct (hereinafter referred to as ICBA), cesium carbonate (Cs₂CO₃), titanium dioxide (TiO₂), poly[(9,9-bis(3'-(N,N-dimethylamino)propyl)-2,7-fluorene)-alt-2,7-(9,9-dioctyl-fluorene)] (hereinafter, referred to as PFN), Bathocuproine (hereinafter referred to as BCP), zirconium oxide (ZrO), zinc oxide (ZnO), or polyethynimine.

A brookite-type titanium oxide layer can be provided between the photoelectric conversion layer and the transparent electrode. It is known that titanium oxide has three types of crystal structures of a rutile type, an anatase type, and a brookite type. In the embodiment, it is preferable to use a layer including brookite-type titanium oxide of these. This brookite-type titanium oxide layer exhibits an effect of suppressing movement of halogen from the photoelectric conversion layer to the conductive layer and movement of metal ions from the conductive layer to the photoelectric conversion layer. Therefore, the life of the electrode and the electronic device can be prolonged. Such a brookite-type titanium oxide layer is preferably composed of nanoparticles of brookite-type titanium oxide, specifically, particles having an average particle size of 5 to 30 nm. Herein, the average particle size has been measured by a particle size distribution measuring apparatus. Such brookite-type nanoparticles are commercially available, for example, from Kojundo Chemical Laboratory Co., Ltd.

An optional electrode can be used, and the transparent electrode according to the embodiment can also be used as the counter electrode 330. An opaque metal electrode is widely used. There is used, as a material of such a metal electrode, stainless steel, copper, titanium, nickel, chromium, tungsten, gold, silver, molybdenum, tin, or zinc.

In addition, the counter electrode 330 may contain unsubstituted planar monolayer graphene. The unsubstituted monolayer graphene can be formed by a CVD method in which a copper foil is used as a base catalyst layer and methane, hydrogen, or argon as a reaction gas. For example, a thermal transfer film and monolayer graphene are pressure-bonded, then copper is dissolved, and the monolayer graphene is transferred onto the thermal transfer film. Repeating the same operation can laminate a plurality of monolayer graphene on the thermal transfer film, and 2 to 4 layers of graphene layers are formed. A metal wiring for current collection is printed on this film by using a silver paste or the like, whereby a counter electrode can be formed. Instead of unsubstituted graphene, graphene in which a part of carbon is substituted with boron may be used. Boron-substituted graphene can be formed in the same manner by using BH₃, methane, hydrogen, or argon as a reaction gas. These graphenes can also be transferred from a thermal transfer film onto a suitable substrate such as PET.

In addition, these monolayer or multilayer graphenes may be doped with a tertiary amine as an electron donor molecule. An electrode composed of such a graphene layer also functions as a transparent electrode.

The solar battery cell according to the embodiment may have a structure in which both surfaces are sandwiched between transparent electrodes.

The solar battery cell having such a structure can efficiently utilize light from both surfaces. The energy conversion efficiency is generally 5% or more, and the electrode substrate composed of a transparent polymer provides long-term stability and flexibility.

In addition, a glass transparent electrode having a metal oxide layer such as ITO can be used as the counter electrode 330. In this case, flexibility of the solar battery cell is sacrificed; however, light energy can be used with high efficiency.

The solar battery cell can further include an ultraviolet cut layer, a gas barrier layer, and the like. Specific examples of the ultraviolet absorber include: benzophenone-based compounds such as 2-hydroxy-4-methoxybenzophenone, 2,2-dihydroxy-4-methoxybenzophenone, 2-hydroxy-4-methoxy-2-carboxybenzophenone, and 2-hydroxy-4-n-octoxybenzophenone; benzotriazole-based compounds such as 2-(2-hydroxy-3,5-di-tert-butylphenyl)benzotriazole, 2-(2-hydroxy-5-methylphenyl)benzotriazole, and 2-(2-hydroxy-5-tert-octylphenyl)benzotriazole; and salicylic acid ester-based compounds such as phenyl salicylate and p-octylphenyl salicylate. These compounds desirably cut ultraviolet rays having 400 nm or less.

The gas barrier layer blocking particularly water vapor and oxygen is preferable, and a gas barrier layer that hardly passes water vapor is particularly preferable. For example, a layer composed of an inorganic material of SiN, SiO₂, SiC, SiOₓN_{y}, TiO₂, or Al₂O₃, ultra-thin glass, or the like can be preferably used. The thickness of the gas barrier layer is not particularly limited, and is preferably in the range of 0.01 to 3000 µm, and more preferably in the range of 0.1 to 100 µm. Sufficient gas barrier properties tend not to be obtained at less than 0.01 µm, and whereas, characteristics such as flexibility and softness tend to disappear due to an increase in thickness at more than 3000 µm. The water vapor transmission amount (moisture permeability) of the gas barrier layer is preferably 10² g/m²·d to 10⁻⁶ g/m²·d, more preferably 101 g/m²·d to 10⁻⁵ g/m²·d, and still more preferably 100 g/m²·d to 10⁻⁴ g/m²·d. The moisture permeability can be measured in accordance with JIS Z0208 or the like. A dry method is preferable for forming a gas barrier layer. Examples of a method of forming a gas barrier layer having a gas barrier property by a dry method include: vacuum vapor deposition methods such as a resistance heating vapor deposition, an electron beam vapor deposition, an induction heating vapor deposition, and an assist method using a plasma or an ion beam; sputtering methods such as a reactive sputtering method, an ion beam sputtering method, or an electron cyclotron (ECR) sputtering method; a physical vapor deposition method (PVD method) such as an ion plating method; and a chemical vapor deposition method (CVD method) using heat, light, plasma, or the like. Of these, there is preferable the vacuum vapor deposition method in which a layer is formed by a vapor deposition method under vacuum.

The transparent electrode according to the embodiment includes a substrate. However, after the production of a transparent substrate, the transparent substrate can be removed as necessary. Specifically, in the production process of the electronic device, the transparent substrate and the photoelectric conversion layer formed thereon are integrated, and then the substrate can be peeled off and removed. In such a case, the substrate is a support for forming the electrode structure, and therefore does not need to be transparent, and metal, an opaque resin material, or the like can be used.

The solar battery cell of the present embodiment can also be used as a photosensor.

### [Embodiment 3-2]

FIG. 4 is a schematic configuration view of an organic EL element 400 according to the third different embodiment. The organic EL element 400 is an element having a function as a light emitting element that converts electric energy input to this element into light L. The organic EL element 400 includes a transparent electrode 410 according to the embodiment, a counter electrode 430, and a photoelectric conversion layer (light emitting layer) 420 provided therebetween.

Herein, the transparent electrode 410 corresponds to the first embodiment, and has a plurality of conductive regions having a structure in which a transparent substrate 411, a first transparent conductive metal oxide layer 412, a metal layer 413, a second transparent conductive metal oxide layer 414, and a graphene-containing layer 415 are laminated, and there is a high resistance region 417 therebetween.

The photoelectric conversion layer 420 is a layer that recombines the charge injected from the transparent electrode 410 and the charge injected from the counter electrode 430 to convert electric energy into light. The photoelectric conversion layer 420 generally includes a p-type semiconductor layer and an n-type semiconductor layer, and optional materials having a photoelectric conversion function can be used. A buffer layer may be provided between the photoelectric conversion layer 420 and the counter electrode 430 to promote or block charge injection, and another buffer layer may also be provided between the photoelectric conversion layer 420 and the transparent electrode. The counter electrode 430 is typically a metal electrode; however, a transparent electrode may be used.

### EXAMPLES

### (Example 1)

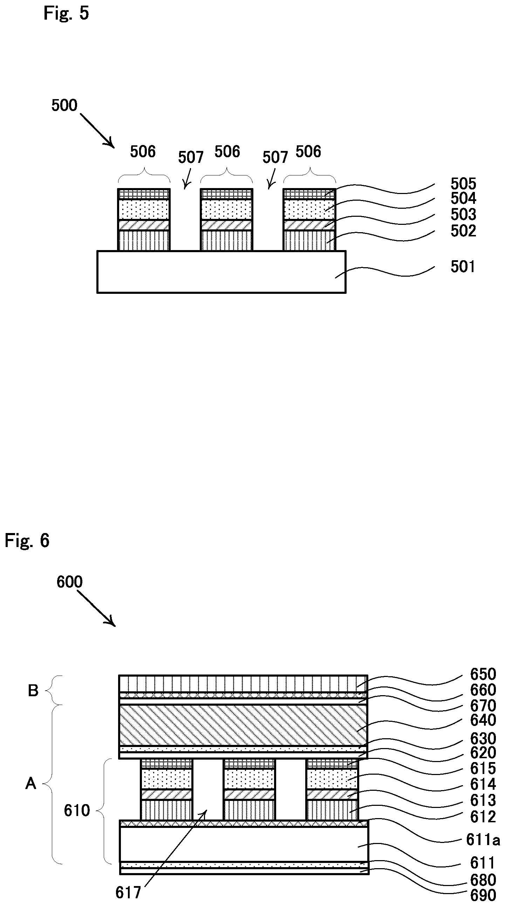

A transparent electrode 500 having the structure shown in FIG. 5 is produced.

A laminated structure of an amorphous ITO (a-ITO) layer 502, an alloy layer 503 including silver and palladium, and an a-ITO layer 504 is formed on a 100 µm PET film 501 by a sputtering method. The surface resistance of this laminated structure is 8 to 10 Ω/□. There are laminated thereon a planar average four layers of planar N-graphene-containing layers 505 having a part of carbon atoms substituted with nitrogen atoms. This N-graphene-containing layer functions as a barrier layer.

The barrier layer is formed as follows. The surface of the Cu foil is heat-treated by laser irradiation, and the crystal grains are enlarged by annealing. This Cu foil is used as a base catalyst layer, and ammonia, methane, hydrogen, and argon (15 : 60 : 65 : 200 ccm) are used as a mixed reaction gas at 1000°C for 5 minutes to produce a planar monolayer N-graphene layer by a CVD method. In this case, a monolayer graphene layer is formed in most portions, and a portion with two or more layers of N-graphene laminated is also generated depending on conditions; however, the portion is conveniently referred to as a monolayer graphene layer. Furthermore, treatment is performed at 1000°C for 5 minutes under an ammonia/argon mixed gas stream, and then cooling is performed under an argon stream. The monolayer N-graphene layer is transferred onto the thermal transfer film by pressure-bonding the thermal transfer film (150 µm thick) and the monolayer N-graphene and then immersing in an ammonia alkaline cupric chloride etchant in order to dissolve Cu. Repeating the same operation laminated four layers of the monolayer graphene layers on the thermal transfer film to provide a multilayer N-graphene layer.

The thermal transfer film is laminated on the prepared laminated structure, and then the N-graphene layer is transferred onto the laminated structure by heating to form the barrier layer 505.

The nitrogen content of the barrier layer 505 (graphene-containing layer) measured by XPS is 1 to 2 atm% under this condition. The ratio between carbon atoms and oxygen atoms of the carbon material measured by XPS is 100 to 200.

Then, conductive regions 506 separated by a separation region 507 having a width of about 70 µm are formed at intervals of 13 mm by mechanical scribing.

This transparent electrode is immersed in 3% salt water, and a potential is applied at + 0.5 V (silver-silver chloride electrode) for 10 minutes. When the sheet resistance after water washing is measured, the increase in resistance is 5% or less.

### (Comparative Example 1)

A transparent electrode is formed in the same manner as in Example 1, then the monolayer graphene layer is further transferred, and both the conductive region and the separation region are coated with graphene. This transparent electrode is immersed in 3% salt water, and a potential is applied at + 0.5 V (silver-silver chloride electrode) for 10 minutes. When the sheet resistance after water washing is measured, the increase in resistance is 20% or more.

### (Example 2)

A transparent electrode is produced in the same manner as in Example 1. Then, conductive regions separated by the separation region having a width of about 40 µm are formed at intervals of 13 mm by laser scribing. This transparent electrode is immersed in 3% salt water, and a potential is applied at + 0.5 V (silver-silver chloride electrode) for 10 minutes. When the sheet resistance after water washing is measured, the increase in resistance is 10% or less.

### (Example 3)

In the same manner as in Example 1, a laminated structure of a-ITO/alloy layer/a-ITO is formed on a 100 µm PET film by a sputtering method. The surface resistance is 8 to 10 Q/o. There is formed thereon a planar barrier layer in which N-graphene layers with a part of carbon atoms substituted with nitrogen atoms are laminated.

The barrier layer is formed as follows. The aqueous dispersion liquid including graphene oxide and polyethyleneimine is heated at 90°C for 1 hour. Then, hydrated hydrazine is added to the dispersion liquid, the mixture is further heated for 1 hour, and then the whole mixture is centrifuged at 12000 rpm. After removing the supernatant, the precipitate is redispersed with water. Centrifugation and removal of the supernatant are repeated three times. Finally, the redispersion is performed with ethanol. An N-graphene-containing layer (barrier layer) is formed on the laminated structure by being subjected to meniscus application of the ethanol redispersion liquid onto the laminated structure and then drying.

The nitrogen content of the barrier layer measured by XPS is 4 to 5 atm% under this condition. The ratio between carbon atoms and oxygen atoms of the carbon material measured by XPS is 5 to 10.

Then, conductive regions separated by separation regions having a width of about 70 µm are formed at intervals of 13 mm by mechanical scribing. This transparent electrode is immersed in 3% salt water, and a potential is applied at + 0.5 V (silver-silver chloride electrode) for 10 minutes. When the sheet resistance after water washing is measured, the increase in resistance is 10% or less.

### (Example 4)

An 2-propanol solution containing 5% by mass of niobium (V) butoxide with respect to titanium (IV) isopropoxide is subjected to meniscus application onto the transparent electrode obtained in Example 3. Drying is performed at room temperature in a nitrogen atmosphere, and then drying is performed on a hot plate at 130°C in the atmosphere with a humidity of 40%. This operation formed an n-type titanium oxide layer doped with Nb on the N-graphene-containing layer.

This transparent electrode is immersed in 3% salt water, and a potential is applied at + 0.5 V (silver-silver chloride electrode) for 10 minutes. When the sheet resistance after water washing is measured, the increase in resistance is 5% or less.

### (Example 5)

A solar battery cell 60 illustrated in FIG. 6 is produced.

A laminate including an a-ITO layer 612, an alloy layer 613, an a-ITO layer 614, and a graphene-containing layer 615 is formed by the same method as in Example 3 on the PET substrate 611 on which a copper grid 611a having a hexagonal lattice shape and a line width of 50 µm is formed. Then, a separation region 617 is formed by scribing to form a transparent electrode 610. In this case, the scribing is performed by adjusting the strength so that the copper grid 611a is not removed. An aqueous solution of lithium fluoride is applied thereon to form an electron injection layer 620. Then, a toluene solution of C60-PCBM is applied with a bar coater and dried to form an electron transport layer 630. A chlorobenzene solution including poly(3-hexylthiophene-2,5-diyl) and C60-PCBM is applied with a bar coater and dried at 100°C for 20 minutes to form a photoelectric conversion layer 640. Thus, a laminate A is formed.

There is prepared a stainless foil 650 having an insulating ceramic layer (not illustrated) formed on one surface. The surface of the plane on which no insulating ceramic layer is formed is treated with dilute hydrochloric acid to remove the surface oxide film, and then an aqueous solution of graphene oxide is applied with a bar coater to form a graphene oxide-containing layer. Then, after drying at 90°C for 20 minutes, the graphene oxide containing layer is treated with hydrated hydrazine vapor at 110°C for 1 hour to change to an N-graphene containing layer (barrier layer) 660 including a bilayer N-graphene layer in which a part of carbon atoms of the graphene oxide is substituted with nitrogen atoms.

An aqueous solution of PEDOT/PSS containing sorbitol is applied onto the N-graphene-containing layer 660 with a bar coater, and dried at 100°C for 30 minutes to form a layer 670 (50 nm thick) including PEDOT/PSS. This PEDOT/PSS layer functions as an adhesive layer and a hole injection layer. Thus, a laminate B is formed.

The photoelectric conversion layer 640 of the laminate A and the PEDOT/PSS layer 670 of the laminate B are bonded at 90°C to be connected each other.

The ultraviolet cutting ink containing 2-hydroxy-4-methoxybenzophenone is screen-printed on the back surface of the laminate A to form an ultraviolet cutting layer 680. A silica film is formed on the ultraviolet cutting layer by a vacuum vapor deposition method to form a gas barrier layer 690, thereby forming a solar battery cell 600.

The obtained solar battery cell exhibits an energy conversion efficiency of 5% or more with respect to 1 SUN of sunlight, and although left outdoors for one month, the efficiency degradation is less than 1%.

### (Example 6)

An organic EL element is produced. A laminate including an a-ITO layer, an alloy layer 613, an a-ITO layer, and a graphene-containing layer is formed by the same method as in Example 3 on the PET substrate on which a copper grid having a hexagonal lattice shape and a line width of 50 µm is formed. Then, a separation region is formed by scribing to form a transparent electrode. In this case, the scribing is performed by adjusting the strength so that the copper grid is not removed. An aqueous solution of lithium fluoride is applied thereon as an electron transport layer, and tris(8-hydroxyquinoline)aluminum (Alq₃) (40 nm), which also functions as an n-type semiconductor and is a light emitting layer, is vapor-deposited to form a photoelectric conversion layer. N,N'-di-1-naphthyl-N,N'-diphenyl-1,1'-biphenyl-4,4'-diamine (hereinafter, referred to as NPD) is vapor-deposited thereon in a thickness of 30 nm to form a hole transport layer. A gold electrode is formed thereon by a sputtering method. An organic EL element is formed by further sealing the periphery of the formed element. The obtained organic EL element has little deterioration in output light, and the reduction in output is 3% or less regardless of continuous operation for 1000 hours.

### REFERENCE SIGNS LIST

- 100: transparent electrode
- 101: transparent substrate
- 102: first transparent conductive oxide layer
- 103: metal layer
- 104: second transparent conductive oxide layer
- 105: graphene-containing layer
- 106: conductive region
- 107: high resistance region
- 200: solar battery cell
- 201: transparent substrate
- 202: first transparent conductive oxide layer
- 203: metal layer
- 204: second transparent conductive oxide layer
- 205: graphene-containing layer
- 206: laminate
- 206a: conductive region
- 207: high resistance region
- 300: solar battery cell
- 310: transparent electrode
- 311: transparent substrate
- 312: first transparent conductive oxide layer
- 313: metal layer
- 314: second transparent conductive oxide layer
- 315: graphene-containing film
- 317: high resistance region
- 320: photoelectric conversion layer
- 330: counter electrode
- 400: organic el element
- 410: transparent electrode
- 411: transparent substrate
- 412: first transparent conductive oxide layer
- 413: metal layer
- 414: second transparent conductive oxide layer
- 415: graphene-containing film
- 417: high resistance region
- 420: photoelectric conversion layer (light emitting layer)
- 430: counter electrode
- 500: transparent electrode
- 501: pet film
- 502: a-ITO
- 503: alloy of silver and Pd
- 504: a-ITO
- 505: N-graphene containing layer
- 506: conductive region
- 507: high resistance region
- 600: solar battery cell
- 610: transparent electrode
- 611: PET substrate
- 611a: copper grid
- 612: a-ITO layer
- 613: alloy layer
- 614: a-ITO layer
- 615: N-graphene containing layer
- 620: electron injection layer
- 630: electron transport layer
- 640: photoelectric conversion layer
- 650: stainless foil
- 660: N-graphene layer
- 670: layer including PEDOT/PSS
- 680: ultraviolet cutting layer
- 690: gas barrier layer

## Claims

1. A transparent electrode, comprising:
a transparent substrate; and
a plurality of conductive regions disposed on a surface of said transparent substrate and separated from each other by a high resistance region, wherein
said conductive regions have a structure in which a first transparent conductive metal oxide layer, a metal layer, a second transparent conductive metal oxide layer, and a graphene-containing layer are laminated in this order from a side of the substrate, and
no compound having a graphene skeleton exists in said high resistance region.

2. The transparent electrode according to claim 1, wherein a part of carbons constituting a graphene skeleton of graphene included in said graphene-containing layer is substituted with nitrogen.

3. The transparent electrode according to claim 1 or 2, wherein a polyalkyleneimine chain is bonded to a graphene skeleton of graphene included in said graphene-containing layer.

4. The transparent electrode according to any one of claims 1 to 3, wherein said separation region is filled with a material comprising a p-type inorganic oxide, an n-type inorganic oxide, a p-type organic compound, or an n-type organic compound.

5. The transparent electrode according to any one of claims 1 to 4, wherein said transparent conductive oxide is indium-doped tin oxide, fluorine-doped tin oxide, aluminum-doped zinc oxide, or indium-doped zinc oxide.

6. The transparent electrode according to any one of claims 1 to 5, further comprising a layer including a p-type inorganic oxide, an n-type inorganic oxide, a p-type organic compound, or an n-type organic compound on said graphene-containing layer.

7. The transparent electrode according to any one of claims 1 to 6, further comprising a graphene oxide-containing layer on said graphene-containing layer.

8. A method of producing a transparent electrode, comprising:
(a) a step of preparing a transparent substrate:
(b) a step of forming a laminate, comprising:
(b1) a step of forming a first transparent conductive metal oxide layer on said transparent substrate;
(b2) a step of forming a metal layer on said first transparent conductive metal oxide layer;
(b3) a step of forming a second transparent conductive metal oxide layer on said metal layer; and
(b4) a step of forming a graphene-containing layer on said second transparent conductive metal oxide layer; and
(c) a step of patterning said laminate to form a plurality of conductive regions.

9. The method according to claim 8, wherein said step (c) is performed by mechanical scribing, laser scribing, or etching.

10. The method according to claim 8 or 9, wherein said step (b4) is performed by applying an aqueous dispersion liquid including graphene oxide onto said second transparent conductive metal oxide layer, and then reducing the graphene oxide with hydrazine.

11. The method according to claim 10, wherein said aqueous dispersion liquid further comprises a polyalkyleneimine.

12. The method according to claim 8 or 9, wherein said step (b4) is performed by applying an aqueous dispersion liquid including graphene having polyethyleneimine chains bonded thereto onto said second transparent conductive metal oxide layer.

13. The method according to any one of claims 8 to 12, further comprising a step (b5) of forming a graphene oxide-containing layer on said graphene-containing film between said step (b4) and said step (c).

14. The method according to any one of claims 8 to 13, comprising no step of using a compound having a graphene skeleton after said step (c).

15. The method according to any one of claims 8 to 14, wherein a void between said plurality of conductive regions is filled with an insulating material after said step (c).

16. An electronic device, comprising a structure in which said transparent electrode according to any one of claims 1 to 7, an active layer, and a counter electrode are laminated in this order.

17. An electronic device according to claim 16, wherein said active layer is a photoelectric conversion layer.

18. The electronic device according to claim 17, wherein said active layer comprises a halogen ion or a sulfur compound.
